# EUROPÄISCHE PATENTSCHRIFT

(11) **EP 2 913 859 B1**
(45) Veröffentlichungstag und Bekanntmachung des Hinweises auf die Patenterteilung: **31.05.2017**
(21) Anmeldenummer: 14004236.7
(22) Anmeldetag: 16.12.2014
(51) Int. Cl.: H02N 2/04

(54) **ELASTOMER-AKTUATOR**
ELASTOMER-ACTUATOR
ACTIONNEUR ÉLASTOMÈRE

(30) Priorität: 27.02.2014 DE 102014002739
(43) Veröffentlichungstag der Anmeldung: 02.09.2015
(73) Patentinhaber: FESTO AG & Co. KG, 73734 Esslingen (DE)
(72) Erfinder: Giousouf, Metin, D-73732 Esslingen (DE); Pointner, Tobias, D-73033 Göppingen (DE)
(74) Vertreter: Patentanwälte Magenbauer & Kollegen Partnerschaft mbB

(56) Entgegenhaltungen:
- WO-A1-2012/171681
- WO-A1-2013/122110

## Beschreibung

Die Erfindung betrifft einen Elastomer-Aktuator, mit einer zumindest partiell über elastomere Eigenschaften verfügenden Antriebsstruktur, die eine in einer Höhenrichtung verlaufende Hochachse aufweist und die bei elektrischer und/oder magnetischer Aktivierung eine Haupt-Verformung in der Höhenrichtung erfährt und dabei aufgrund überlagerter Materialdehnungen rechtwinkelig zu der Höhenrichtung ihre Querabmessungen verändert, wobei an wenigstens einer Stirnseite der Antriebsstruktur ein im Vergleich zu der Antriebsstruktur starrer Kraftabgabeabschnitt angeordnet ist und wobei zwischen dem Kraftabgabeabschnitt und der Antriebsstruktur eine über anisotrope Festigkeitseigenschaften verfügende, in der Höhenrichtung steif und in dazu rechtwinkeliger Richtung flexibel ausgebildete Kraftübertragungsstruktur angeordnet ist.

Aus der WO 2012/171681 A1 ist ein derartiger Elastomer-Aktuator bekannt, bei dem zwischen einem eine Antriebsstruktur bildenden EAP-Stapel und einer kraftübertragenden Fläche eine die Reibung verringernde Schicht angeordnet ist, in der mit Schmiermittel gefüllte Kammern ausgebildet sind, die über Kanäle mit einem Spalt verbunden sind, der zwischen dem EAP-Stapel und der Reibung verringernden Schicht angeordnet ist. Die die Reibung verringernde Schicht kann verformt werden, sodass das Schmiermittel aus den Kammern in den Spalt gepresst wird.

In dem Artikel "Dielectric elastomer actuators used for pneumatic valves technology", Metin Giousouf und Gabor Kovacs, veröffentlicht in "Smart Materials and Structures", 2013, Seiten 1 bis 6, wird ein Elastomer-Aktuator beschrieben, der als Antriebseinheit für ein Pneumatikventil genutzt wird. Der bekannte Elastomer-Aktuator ist als ein dielektrischer Elastomer-Aktuator ausgebildet, der über eine mehrschichtige Antriebsstruktur verfügt, die sich aus einer Vielzahl von aufeinandergestapelten Elastomermaterialschichten und dazwischen angeordneten Elektrodenschichten zusammensetzt. Bei Anlegen einer Ansteuerspannung an die Elektrodenschichten bilden sich elektrostatische Felder aus, durch die die sich gegenüberliegenden Elektrodenschichten zueinandergezogen werden, wodurch die dazwischen liegende Elastomermaterialschicht in der Höhenrichtung der Antriebsstruktur komprimiert wird. Auf diese Weise zieht sich die gesamte Antriebsstruktur zusammen, wobei auch stirnseitig an der Antriebsstruktur angeordnete starre Kraftabgabeabschnitte zueinander bewegt werden. Während einer dieser beiden Kraftabgabeabschnitte als Befestigungssockel benutzt wird, fungiert der andere Kraftabgabeabschnitt als Träger für ein Dichtelement, das in einem Pneumatikventil die Funktion eines Ventilgliedes übernimmt. Um eine möglichst große Auslenkung des Elastomer-Aktuators und folglich des zugeordneten Ventilgliedes zu ermöglichen, bedarf es einer relativ großen Anzahl von Elastomermaterialschichten, deren Zusammenfügen zu der Antriebsstruktur sehr aufwendig und mit hohen Kosten verbunden ist.

In dem Artikel "Dielectric Elastomer Actuators - Potential Use in Automation Technology", M. Giousouf, Festo AG & Co. KG, aus "ACTUATOR 2012", Seiten 358 bis 361, wird der Aufbau dielektrischer Elastomer-Aktuatoren beschrieben, die sich für den Einsatz in der Automatisierungstechnik eignen und auf deren Grundlage ebenfalls Pneumatikventile realisierbar sind.

Der Artikel "Experimental characterization of the hysteretic and rate-dependent electromechanical behavior of dielectric electro-active polymer actuators", A. York, J. Dunn und S. Seelecke, veröffentlicht in "Smart Materials and Structures" 2010, Seiten 1 bis 9, beschreibt den Aufbau dielektrischer elektroaktiver Polymeraktuatoren, die eine Membranform haben und deren Funktionsprinzip darauf basiert, dass an zwei eine Elastomermaterialschicht flankierende Elektroden eine Ansteuerspannung angelegt wird, sodass sich elektrostatische Kräfte ausbilden, die die Elastomermaterialschicht zusammendrücken. Das Zusammendrücken der Elastomermaterialschicht geht wie bei den anderen weiter oben beschriebenen Elastomer-Aktuatoren mit einer Materialdehnung rechtwinkelig zur Wirkrichtung der elektrostatischen Kräfte einher.

Der Erfindung liegt die Aufgabe zugrunde, einen Elastomer-Aktuator zu schaffen, der bei kompakten Abmessungen eine relativ große Auslenkung in seiner Höhenrichtung ermöglicht.

Diese Aufgabe wird in Verbindung mit den eingangs genannten Merkmalen durch die Merkmale des kennzeichnenden Teils des Anspruchs 1 oder des Anspruchs 3 gelöst.

Der Kraftabgabeabschnitt mit zugeordneter Kraftübertragungsstruktur kann je nach Einsatzzweck des Elastomer-Aktuators wahlweise nur an einer Stirnseite oder an beiden Stirnseiten der elastisch verformbaren Antriebsstruktur angeordnet sein.

Die beim Einsatz des Elastomer-Aktuators genutzte Haupt-Verformung in der Höhenrichtung der Antriebsstruktur geht stets mit einer überlagerten Materialdehnung in zur Höhenrichtung rechtwinkeliger Querrichtung der Antriebsstruktur einher. Somit verbreitern sich die Querabmessungen der Antriebsstruktur, wenn sie axial komprimiert wird. Diese Querdehnungen kann der mindestens eine stirnseitig vorgelagerte Kraftabgabeabschnitt aufgrund seiner starren Struktur nicht mitmachen. Der Kraftabgabeabschnitt bedarf einer Steifigkeit, die größer ist als diejenige der Antriebsstruktur, damit er ohne Beschädigungsgefahr und ohne sich relevant zu verformen in der Lage ist, Aktuatorkräfte nach außen abzugeben, um auf eine externe Komponente eine Kraft auszuüben und/oder um eine Hubbewegung auszuführen. Die damit verbundene Kraftübertragung erfordert eine axiale, in der Höhenrichtung der Antriebsstruktur orientierte Abstützung des Kraftabgabeabschnittes an der Antriebsstruktur. Dies wiederum behindert normalerweise die Querdehnung der Antriebsstruktur in dem dem Kraftabgabeabschnitt zugewandten Endbereich, was wiederum das Komprimierungsverhalten der Antriebsstruktur beeinträchtigt. Erfindungsgemäß ist diese Problematik zu einem großen Teil ausgeräumt, da die zwischen dem Kraftabgabeabschnitt und der Antriebsstruktur eingegliederte Kraftübertragungsstruktur eine Entkopplung zwischen der Antriebsstruktur und dem Kraftabgabeabschnitt in der Querrichtung bewirkt, die der Antriebsstruktur auch im Bereich ihrer axialen Endabschnitte weitestgehend ungehinderte Querdehnungen ermöglicht. Gleichwohl sorgt die anisotrope Festigkeitscharakteristik der Kraftübertragungsstruktur dafür, dass nach wie vor eine zumindest annähernd uneingeschränkte Kraftübertragung zwischen der Antriebsstruktur und dem Kraftabgabeabschnitt in der Höhenrichtung und mithin in der Richtung der Haupt-Verformung der Antriebsstruktur möglich ist. Dadurch, dass das Querdehnungsverhalten der Antriebsstruktur somit weit weniger stark beeinträchtigt ist als bei einem unmittelbaren Kontakt der Antriebsstruktur mit einem insgesamt starren Kraftabgabeabschnitt, lässt sich eine gewünschte axiale Auslenkung mit einer reduzierten Bauhöhe der Antriebsstruktur verwirklichen, was insgesamt einen Aufbau mit kompakten Abmessungen ermöglicht. Die für eine angestrebte Auslenkung erforderliche Bauhöhe der Antriebsstruktur ist im Vergleich zu konventionellen Elastomer-Aktuatoren reduziert, was die Herstellungsdauer und folglich auch die Herstellungskosten verringert. Die reduzierte Bauhöhe verringert auch das Risiko von Funktionsstörungen, weil hochbauende Elastomer-Aktuatoren, die über ein hohes Verhältnis zwischen Bauhöhe und Baubreite verfügen, bei höherer Belastung zum Ausknicken neigen.

Gemäß Anspruch 1 ist die Kraftübertragungsstruktur bezüglich des zugeordneten Kraftabgabeabschnittes separat ausgebildet und verfügt über eine Mehrzahl von Wälzelementen, die zwischen dem Kraftabgabeabschnitt und der Antriebsstruktur eingegliedert sind und die sich bei Querdehnungen der Antriebsstruktur sowohl an dem Kraftabgabeabschnitt als auch stirnseitig an der Antriebsstruktur abwälzen können. Besonders zweckmäßig ist es dabei, wenn die Wälzelemente kugelförmig, also als Wälzkugeln, ausgeführt sind, die in jeder Richtung rollen können, sodass die schon angesprochene vorteilhafte isotrope Flexibilität ermöglicht wird.

Die Wälzelemente sind insbesondere unabhängig voneinander beweglich, sodass sie bei der Querdehnung der Antriebsstruktur unterschiedlich weite Abrollwege zurücklegen können, was vorteilhaft ist, weil sich die Verformung ausgehend vom Zentrum der Antriebsstruktur nach außen hin zunehmend vergrößert.

Gemäß Anspruch 3 besteht die Kraftübertragungsstruktur aus einer Vielzahl von länglichen Stützelementen, die sich einerseits jeweils an dem Kraftabgabeabschnitt abstützen und sich andererseits mit jeweils einer Stirnseite auch an der Antriebsstruktur abstützen. Die Stützelemente sind bevorzugt stabförmig ausgebildet, wobei sie in ihrer axialen Richtung drucksteif und quer dazu flexibel sind. Eine solche Kraftübertragungsstruktur kann die Antriebskräfte der Antriebsstruktur zumindest weitestgehend uneingeschränkt auf den bevorzugt starr und insbesondere plattenförmig ausgebildeten Kraftabgabeabschnitt übertragen und stellt dennoch die angestrebte Quernachgiebigkeit zur Verfügung. Die Stützelemente sind nach Art von Borsten einer Bürste verteilt.

Da die länglichen Stützelemente bevorzugt in jeder Querrichtung flexibel sind, können sie sehr einfach den Anspruch nach einer isotropen Querflexibilität erfüllen.

Die biegsamen Stützelemente sind möglichst dicht gepackt in der zur Hochachse der Antriebsstruktur rechtwinkeligen Querebene verteilt angeordnet. Man kann insbesondere von einer matrixartigen oder wabenartigen Verteilungsstruktur sprechen.

Die länglichen Stützelemente sind am zugeordneten Kraftabgabeabschnitt zweckmäßigerweise unbeweglich angeordnet und erfahren ihre für die Flexibilität der Kraftübertragungsstruktur verantwortliche Querauslenkung dadurch, dass ihr mit der Antriebsstruktur in Kontakt stehender Endabschnitt die Querdehnungsbewegung der Antriebsstruktur mitmacht. Dementsprechend hat bei jedem der länglichen Stützelemente der der Antriebsstruktur zugeordnete stirnseitige Endbereich die größte Querauslenkung.

Die Querauslenkung der länglichen Stützelemente ist umso stärker, je weiter weg sie vom Zentrum der Antriebsstruktur angeordnet sind, weil die auf die Querdehnung zurückzuführende Querverformung des Elastomermaterials der Antriebsstruktur nach außen hin zunimmt. Vor allem vor diesem Hintergrund ist es vorteilhaft, wenn die Stützelemente ausgehend von einem mittleren beziehungsweise zentralen Bereich der Kraftübertragungsstruktur mit zunehmender Entfernung von diesem Bereich eine zunehmende Länge haben. Eine solche Struktur verleiht auch eine bessere Stabilität hinsichtlich der Gefahr des seitlichen Kippens oder Einknickens aller Stützelemente bei einer zu hohen Kraftbelastung.

Eine besonders dicht gepackte Anordnung der Stützelemente ist auch deshalb von Vorteil, weil dadurch ein Eindringen der in der Regel weichen Oberfläche der Antriebsstruktur in die zwischen den benachbarten Stützelementen vorhandenen Zwischenräume verhindert werden kann. Dies gilt auch für die oben erwähnte Ausgestaltung, bei der die Kraftübertragungsstruktur über von Wälzelementen gebildete Stützelemente verfügt.

Es ist von Vorteil, wenn die Stützelemente an ihrem der Antriebsstruktur zugewandten Endbereich über einen kugelförmig oder tropfenförmig verdickten Endabschnitt verfügen, um die zugewandte Stirnfläche der Antriebsstruktur nicht zu beschädigen. Die Tropfenform kann beispielsweise durch das Aufschmelzen eines Drahtendes erfolgen, wenn die Stützelemente aus Metalldrähten hergestellt werden. Ein kugelförmiger Endabschnitt lässt sich beispielsweise dadurch realisieren, dass die Stützelemente über einen drahtförmigen Längenabschnitt verfügen, auf dessen Ende eine Kunststoffkugel aufgebracht ist.

Um die laterale Flexibilität weiter zu verbessern, können die Stützelemente über mindestens eine Einschnürung verfügen, die ein integrales Schwenkgelenk definiert. Eine solche Einschnürung befindet sich insbesondere in der Nähe des Kraftabgabeabschnittes.

Weitere vorteilhafte Weiterbildungen der Erfindung gehen aus den Unteransprüchen hervor.

Der Elastomer-Aktuator ist zweckmäßigerweise als ein dielektrischer elektroaktiver Elastomer-Aktuator ausgebildet. Ein solcher Aktuator verfügt über einen oder mehrere elastomere Abschnitte, der oder die von Elektroden flankiert ist beziehungsweise sind, sodass bei Anlegen einer elektrischen Ansteuerspannung elektrostatische Anziehungskräfte zwischen den Elektroden entstehen, durch die die Elektroden aufeinander zu bewegt werden, sodass das dazwischen liegende Elastomermaterial in Verbindung mit einer Querdehnung zusammengedrückt wird. Bei dem Elastomermaterial handelt es sich insbesondere um ein Silikon-Material, wenngleich prinzipiell jedes gummielastisch verformbare Material sehr gut geeignet ist.

Alternativ zu elektroaktiven Polymeren können zur Realisierung der zumindest partiell über elastomere Eigenschaften verfügenden Antriebsstruktur auch Elastomere mit Magnetpartikeln eingesetzt werden, bei denen sich das Elastomermaterial durch das Anlegen externer Magnetfelder komprimieren oder dehnen lässt. Da Magnetfelder jedoch in vielen Fällen Störungen in der näheren Umgebung hervorrufen können, wird es als zweckmäßiger angesehen, den Elastomer-Aktuator in einer elektrisch aktivierbaren Bauart zu realisieren.

Die Antriebsstruktur hat vorzugsweise einen in ihrer Höhenrichtung, die mit der Richtung der Haupt-Verformung zusammenfällt, mehrschichtigen Aufbau. Mit einer solchen Stapelbauweise wird eine Steigerung des Leistungsvermögens des Elastomer-Aktuators erzielt. Mehrere Elastomermaterialschichten, die insbesondere folienartig ausgebildet sind, sind in der Höhenrichtung aufeinandergestapelt, wobei sich bei der Aktivierung der Antriebsstruktur die in der Höhenrichtung orientierten Verformungen der einzelnen Elastomermaterialschichten zu der die maximale axiale Auslenkung hervorrufenden Gesamtverformung bzw. Haupt-Verformung der Antriebsstruktur addieren.

In Verbindung mit dem Mehrschichtaufbau der Elastomerstruktur ist es bei einem elektroaktiven Elastomer-Aktuator vorteilhaft, wenn die Antriebsstruktur zusätzlich eine Multilayer-Elektrodenanordnung aus mehreren Elektrodenschichten enthält, die in der Höhenrichtung der Antriebsstruktur abwechselnd zu den Elastomermaterialschichten mit zueinander paralleler Ausrichtung in die Antriebsstruktur eingegliedert beziehungsweise eingebettet sind. Legt man an diese Elektrodenanordnung derart eine Ansteuerspannung an, dass die eine jeweilige Elastomermaterialschicht flankierenden Elektrodenschichten gegenpolig geladen werden, so ziehen sich diese Elektrodenschichten gegenseitig an, was eine Komprimierung der in der Höhenrichtung der Antriebsstruktur gemessenen Dicke der einzelnen Elastomermaterialschichten zur Folge hat, sodass die Höhe des Elastomer-Aktuators insgesamt vermindert wird. Infolge des elastischen Materialverhaltens werden dabei zugleich auch die Querabmessungen beziehungsweise Breitenabmessungen rechtwinkelig zur Höhenrichtung der Antriebsstruktur vergrößert.

Die Elektrodenschichten sind fest an den Elastomermaterialschichten angebracht, sodass sie deren Querdehnungen mitmachen. Sie sind zweckmäßigerweise ebenfalls elastisch verformbar. Die Elektrodenschichten bestehen beispielsweise aus Graphitbeschichtungen der Elastomermaterialschichten.

Um die für die axiale Komprimierung der Antriebsstruktur erforderliche, wechselseitig entgegengesetzte Polarisierung der Elektrodenschichten zu erzielen, ist es vorteilhaft, wenn außen an der rechtwinkelig zur Höhenrichtung der Antriebsstruktur orientierten Mantelfläche der Antriebsstruktur zwei streifenförmige Verbindungsleiter angeordnet sind, die sich in der Höhenrichtung der Antriebsstruktur erstrecken, wobei der eine Verbindungsleiter mit allen positiv zu polarisierenden Elektrodenschichten und der andere Verbindungsleiter mit allen negativ zu polarisierenden Elektrodenschichten elektrisch leitend verbunden ist. Zur Aktivierung der Antriebsstruktur genügt es folglich, die benötige Ansteuerspannung an beliebiger Stelle der beiden Elektrodengruppen anzulegen, wofür sich insbesondere die beiden streifenförmigen Verbindungsleiter eignen oder auch die beiden an einander entgegengesetzten Stirnseiten der Antriebsstruktur angeordneten äußeren Elektrodenschichten, die man als End-Elektrodenschichten bezeichnen kann.

Eine besonders vorteilhafte Ausgestaltung der Elektrodenstruktur sieht vor, dass die einzelnen Elektrodenschichten wie die Elastomermaterialschichten einen rechteckigen Umriss haben, jedoch eine kleinere Grundfläche als die Elastomermaterialschichten bedecken und so platziert sind, dass zwischen den auf unterschiedlichem Potential liegenden Elektrodenschichten ein diagonaler Versatz vorliegt, der daraus resultiert, dass die Elektrodenschichten abwechselnd einander entgegengesetzten Eckbereichen der Elastomermaterialschichten zugeordnet sind. So verlaufen jeweils zwei winkelig aneinander angrenzende Außenränder der Elektrodenschichten jeweils bündig mit zwei aneinander angrenzenden äußeren Randflächen der Elastomermaterialschichten, und zwar abwechselnd an einander diagonal gegenüberliegenden Eckbereichen der Elastomermaterialschichten. Dort, wo die Elektrodenschichten bündig mit den äußeren Randflächen der Elastomermaterialschichten verlaufen, sind sie mittels eines sich in der Höhenrichtung der Antriebsstruktur erstreckenden Verbindungsleiters untereinander kontaktiert. In den diagonal gegenüberliegenden Bereichen sind die Außenränder der Elektrodenschichten jedoch bezüglich der äußeren Randflächen der Elastomermaterialschichten zurückversetzt, sodass sich ein abgewinkelter, insbesondere L-förmiger Streifen ergibt, an dem die Elastomermaterialschichten nicht von einer Elektrodenschicht bedeckt sind und der eine Isolationswirkung entfaltet, sodass er als Isolierrandfläche bezeichnet werden kann. Diese Isolierrandfläche sorgt dafür, dass in der Höhenrichtung unmittelbar aufeinanderfolgend angeordnete Elektrodenschichten einen großen Randabstand zueinander haben, sodass Kurzschlüsse aufgrund von Spannungsüberschlägen vermieden werden. Gleichwohl erlaubt die geschilderte Elektrodengestaltung eine sehr großflächige Bedeckung der Elektrodenschichten mit Elektrodenmaterial, was zur Folge hat, dass erhöhte Verformungskräfte auf die Elastomermaterialschichten ausgeübt werden können.

Vorteilhaft ist es in diesem Zusammenhang, wenn die zur gleichen Elektrodengruppe gehörenden Elektrodenschichten in demjenigen Eckbereich durch einen Verbindungsleiter kontaktiert sind, in dem sie bündig mit den äußeren Randflächen der Elastomermaterialschichten ausgerichtet sind. Der zur Kontaktierung dienende Verbindungsstreifen kann dabei ein abgewinkeltes Querschnittsprofil haben und sich an der Mantelfläche der Antriebsstruktur um jeweils einen Eckbereich herum erstrecken.

Um bei der Aktivierung des Elastomer-Aktuators das oben geschilderte Querdehnungvermögen der Antriebsstruktur bezüglich eines sich anschließenden Kraftabgabeabschnitts zu optimieren, ist es vorteilhaft, wenn die Kraftübertragungsstruktur in jeder zu der Höhenrichtung rechtwinkeligen Richtung über flexible Eigenschaften verfügt, mit anderen Worten in einer zu der Hochachse der Antriebsstruktur rechtwinkeligen Querebene isotrop, also richtungsunabhängig nachgiebig bzw. flexibel ist.

Allerdings erreicht man eine Verbesserung der Kompressionsfähigkeit der Antriebsstruktur mittels der erfindungsgemäßen Kraftübertragungsstruktur auch schon dann, wenn sich die Flexibilität auf nicht alle Querrichtungen bezieht und sich beispielsweise auf nur eine Querrichtung beschränkt.

Besonders vorteilhaft ist es, wenn die Kraftübertragungsstruktur an der Antriebsstruktur nur lose anliegt, wobei sie allerdings durch geeignete Maßnahmen, insbesondere Spannmittel, zweckmäßigerweise kraftschlüssig mit der Stirnseite der Antriebsstruktur verspannt ist. Der Elastomer-Aktuator kann beispielsweise über elastische Spannmittel verfügen, die die Antriebsstruktur, jeden Kraftabgabeabschnitt und auch jede Kraftübertragungsstruktur zu einer den Elastomer-Aktuator bildenden Baugruppe zusammenhalten. Solche Spannmittel enthalten vorzugsweise einen die zusammenzuhaltenden Komponenten außen zumindest partiell umschließenden gummielastischen Hüllkörper, beispielsweise eine hochelastische Folie. Ein solcher Hüllkörper kann über die zusammenzuhaltenden Komponenten übergestülpt sein. Er kann auch insbesondere nach Art eines Schrumpfschlauches ausgeführt sein, der beim Zusammenbau des Elastomer-Aktuators über die zusammenzuhaltenden Komponenten gestülpt und anschließend erwärmt wird, sodass er sich zusammenzieht und die genannten Komponenten miteinander verspannt, ohne das Verformungsverhalten der Antriebsstruktur zu beeinträchtigen.

Selbstverständlich können die zusammenzuhaltenden Komponenten des Elastomer-Aktuators auch durch andere Arten von Spannmitteln, beispielsweise Federn oder auch elektromagnetische Kraftfelder, miteinander axial verspannt sein.

Bei einer weiteren Ausführungsform des Elastomer-Aktuators ist die Kraftübertragungsstruktur fest mit der angrenzenden Antriebsstruktur verbunden, beispielsweise durch Verkleben oder Verschweißen.

Eine weitere vorteilhafte Ausgestaltung sieht vor, dass die Kraftübertragungsstruktur und der Kraftabgabeabschnitt fest miteinander verbunden sind, wobei sie insbesondere einstückig miteinander verbunden sein können. Hier besteht auf besonders einfache Art und Weise die vorteilhafte Möglichkeit, die Kraftübertragungsstruktur und den Kraftabgabeabschnitt in einem einheitlich handhabbaren Kraftabgabekörper zu vereinigen. Ein solcher Kraftabgabekörper ist insbesondere in Spritzgusstechnik oder auch in Druckgusstechnik kostengünstig herstellbar.

Wenn beispielsweise eine geeignete Käfigstruktur oder sonstige Haltemittel vorhanden sind, besteht auch bei einer separaten Ausgestaltung der Kraftübertragungsstruktur und des Kraftabgabeabschnittes die Möglichkeit, diese Komponenten in einem einheitlich handhabbaren Kraftabgabekörper zu vereinigen.

Wenn die Kraftübertragungsstruktur zumindest partiell elektrisch leitfähig ist, kann sie in vorteilhafter Weise genutzt werden, um die Ansteuerspannung an die Elektrodenstruktur an zulegen. Besonders vorteilhaft lässt sich dies realisieren, wenn ein die Kraftübertragungsstruktur und den Kraftabgabeabschnitt beinhaltender einstückiger Kraftabgabekörper vorhanden ist, der insgesamt leitfähig ist oder der, insbesondere durch eine Metallisierung leitfähig beschichtet ist, wobei hier dann die Ansteuerspannung an den Kraftabgabeabschnitt anlegbar ist. Die elektrische Kontaktierung mit der Elektrodenstruktur erfolgt durch den Kontakt zwischen der Kraftübertragungsstruktur und der zugeordneten, die Antriebsstruktur stirnseitig abschließenden End-Elektrodenschicht.

Werden die Kraftabgabeabschnitte zum Anlegen der Ansteuerspannung benutzt, können sie mit geeigneten Steckverbindungsmitteln ausgestattet sein, die eine einfache elektrische Kontaktierung elektrischer Leiter ermöglichen, die zur externen Spannungsquelle führen.

Mindestens ein Kraftabgabeabschnitt des Elastomer-Aktuators verfügt zweckmäßigerweise über mindestens eine Befestigungsschnittstelle, die zur Fixierung einer externen Komponente geeignet ist. Eine solche Befestigungsschnittstelle ist beispielsweise als Gewindebohrung oder als Befestigungsöse realisiert. Wird der Elastomer-Aktuator in Verbindung mit einem Ventil zur Steuerung von Fluidströmen eingesetzt, kann mindestens ein Kraftabgabeabschnitt als Träger für ein Ventilglied dienen oder unmittelbar als ein solches Ventilglied ausgebildet sein.

Nachfolgend wird die Erfindung anhand der beiliegenden Zeichnung näher erläutert. In dieser zeigen:
- Figur 1: eine bevorzugtes Ausführungsbeispiel des erfindungsgemäßen Elastomer-Aktuators im Längsschnitt und im deaktivierten Zustand,
- Figur 2: den Elastomer-Aktuator aus Figur 1 in einer entsprechenden Längsschnittdarstellung und im aktivierten Zustand,
- Figur 3: eine isometrische Einzeldarstellung einer bevorzugten Ausführungsform der in den Elastomer-Aktuator integrierten Antriebsstruktur,
- Figur 4: eine Draufsicht der in Figur 3 illustrierten Antriebsstruktur mit einer in der Höhenrichtung orientierten Blickrichtung gemäß Pfeil IV, wobei die Elektrodenschichten der besseren Sichtbarkeit wegen schraffiert angedeutet sind,
- Figur 5: einen Querschnitt durch den Elastomer-Aktuator gemäß Schnittlinie V-V aus Figur 1 mit Blick auf die der Antriebsstruktur zugewandte Stirnseite der Kraftübertragungsstruktur,
- Fig. 6-8: verschiedene vorteilhafte Formgebungen stabförmig ausgebildeter Stützelemente der Kraftübertragungsstruktur,
- Figur 9: einen Längsschnitt durch eine vorteilhafte Ausführungsform eines einstückigen Kraftabgabekörpers, bei dem der Kraftabgabeabschnitt und die Kraftübertragungsstruktur einstückig miteinander ausgebildet sind,
- Figur 10: in einem Längsschnitt und im deaktivierten Zustand eine weitere vorteilhafte Ausführungsform des erfindungsgemäßen Elastomer-Aktuators, und
- Figur 11: den in Figur 10 illustrierten Elastomer-Aktuator im Längsschnitt und im aktivierten Zustand.

Die nachfolgende Beschreibung bezieht sich, sofern im Einzelfall keine anderen Ausführungen gemacht werden, auf alle Ausführungsbeispiele.

Der in seiner Gesamtheit mit Bezugsziffer 1 bezeichnete Elastomer-Aktuator ist bei allen Ausführungsbeispielen als ein dielektrischer elektroaktiver Elastomer-Aktuator 1 realisiert. Er enthält eine Antriebsstruktur 2, die bevorzugt blockförmig oder säulenförmig gestaltet ist und die sich aus der Kombination einer Elastomerstruktur 3 und einer Elektrodenstruktur 4 zusammensetzt. Wird an die Elektrodenstruktur 4 eine elektrische Ansteuerspannung angelegt, bilden sich innerhalb der Elektrodenstruktur 4 elektrostatische Felder aus, die bewirken, dass sich die Elektrodenstruktur 4 zusammenzieht, wodurch die Elastomerstruktur 3 komprimiert wird und sich die in Achsrichtung einer Hochachse 5 der Antriebsstruktur 2 gemessene Höhe dieser Antriebsstruktur 2 verringert. Das Maß der Höhenveränderung ist abhängig von der Höhe der angelegten Ansteuerspannung. Werden die elektrostatischen Felder wieder entfernt, indem die Ansteuerspannung weggenommen und ein Entladen der Elektrodenstruktur 4 ermöglicht wird, kehrt die Antriebsstruktur 2 aufgrund der sich wieder in den nicht komprimierten Ausgangszustand zurückverformenden Elastomerstruktur 3 in ihren Ausgangszustand mit der zugehörigen Ausgangshöhe zurück.

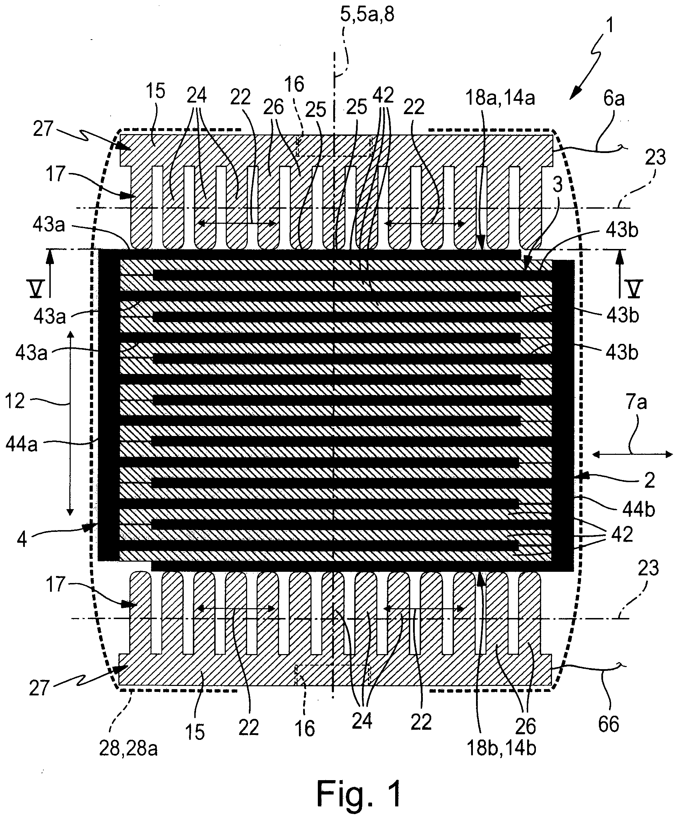

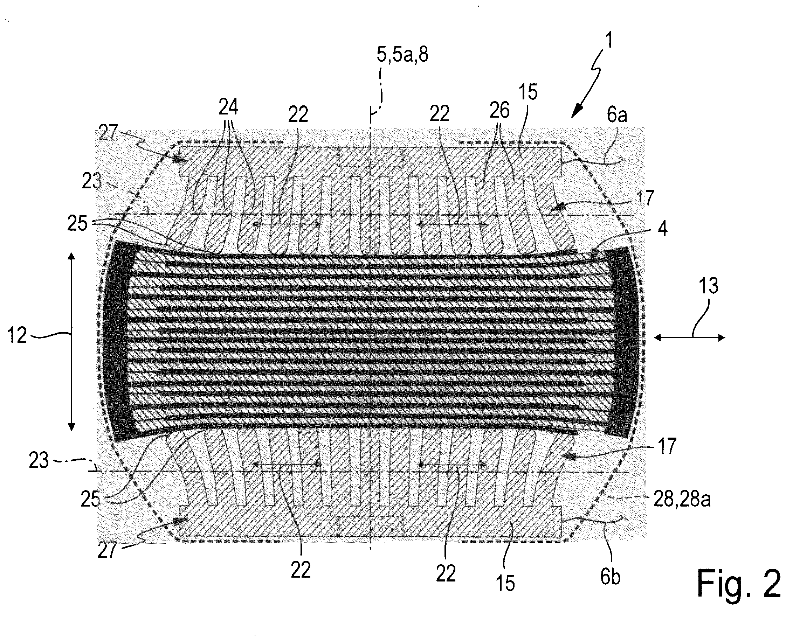

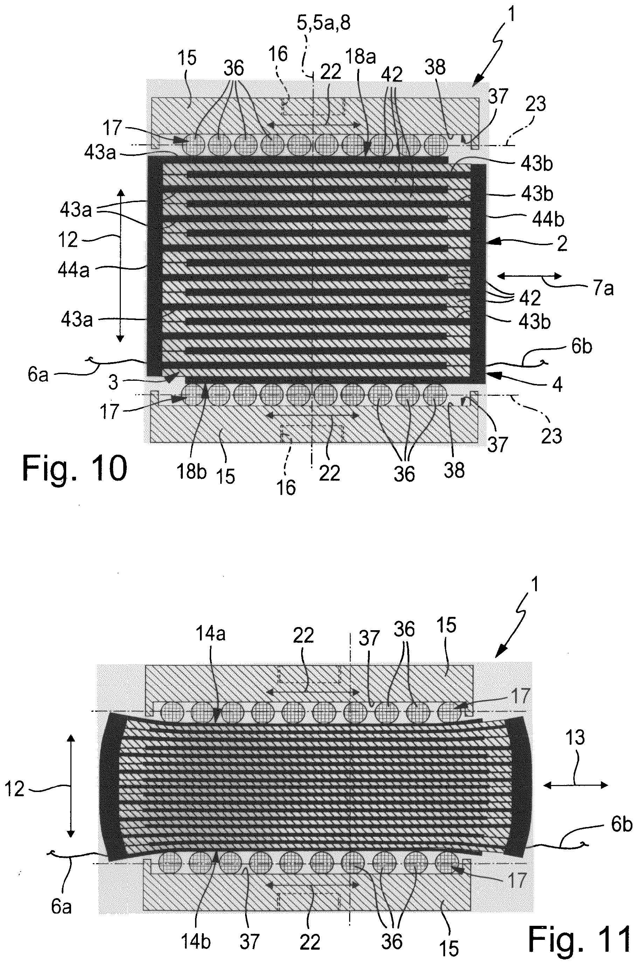

Die Figuren 1 und 10 zeigen den Elastomer-Aktuator 1 im elektrisch deaktivierten Zustand. Die Figuren 2 und 11 illustrieren den elektrisch aktivierten Zustand. Anlegbar ist die Ansteuerspannung insbesondere mittels in geeigneter Weise mit der Elektrodenstruktur 4 kontaktierten Anschlussleitern 6a, 6b beliebiger Art.

Im Folgenden sei die Achsrichtung der Hochachse 5 auch als axiale Richtung oder Höhenrichtung 5a der Antriebsstruktur 2 bezeichnet. Jede zu der Höhenrichtung 5a rechtwinkelige Richtung sei als Querrichtung 7a bezeichnet und ist in der Zeichnung durch einen Doppelpfeil angedeutet. Der Elastomer-Aktuator 1 hat insgesamt eine Längsachse 8, die mit der Hochachse 5 der Antriebsstruktur 2 zusammenfällt.

Die bei der elektrischen Aktivierung der Antriebsstruktur 2 in der Höhenrichtung 5a auftretende Verformung der Antriebsstruktur 2 sei im Folgenden auch als Haupt-Verformung 12 bezeichnet. Mit dieser Haupt-Verformung 12 geht aufgrund der Inkompressibilität der Elastomerstruktur 3 eine auf Materialdehnungen des Elastomermaterials basierende Querverformung der Antriebsstruktur 2 in jeder Querrichtung 7a einher, woraus eine Veränderung der zur Hochachse 5 rechtwinkeligen Querabmessungen der Antriebsstruktur 2 resultiert. Wird die Antriebsstruktur 2 im Rahmen der Haupt-Verformung 12 komprimiert, dehnt sie sich gleichzeitig im Rahmen einer überlagerten, ebenfalls durch einen Doppelpfeil illustrierten Quer-Verformung 13 aus und wird ringsum breiter. Bei der Deaktivierung des Elastomer-Aktuators 1 verformt sich die Antriebsstruktur 2 hinsichtlich ihrer Querabmessungen aufgrund der Elastizität der Elastomerstruktur 3 wieder auf das Ursprungsmaß zurück.

Der Elastomer-Aktuator 1 wird bevorzugt in einer Weise eingesetzt, bei der seine Haupt-Verformung 12 genutzt wird, um irgendwelche Aktionen hervorzurufen oder auszuführen. Solche Aktionen können beispielsweise die Bewegung eines externen Gegenstandes sein, beispielsweise eines Maschinenteils. Eine weitere vorteilhafte Anwendung ist die der Betätigung eines Ventilgliedes zur Steuerung einer Fluidströmung, insbesondere in Verbindung mit Druckluft, aber auch in Verbindung mit anderen fließfähigen Medien. Das zu bewegende Ventilglied kann eine externe Komponente oder auch ein integraler Bestandteil des Elastomer-Aktuators sein.

Um die aus einer abwechselnden Aktivierung und Deaktivierung der Antriebsstruktur 2 resultierende Haupt-Verformung 12 als Kraft oder Hub nach außen zu übertragen, ist beiden Stirnseiten 14a, 14b der Antriebsstruktur 2, die einander entgegengesetzt in der Höhenrichtung 5a orientiert sind, jeweils ein Kraftabgabeabschnitt 15 vorgelagert, auf den die aus der Haupt-Verformung 12 resultierende Antriebskraft der Antriebsstruktur 2 übertragen wird. Der Kraftabgabeabschnitt 15 ist ein im Vergleich zur Antriebsstruktur 2 starres Gebilde und ist zweckmäßigerweise insgesamt in einer Weise starr ausgebildet, dass er beim bestimmungsgemäßen Einsatz des Elastomer-Aktuators 1 zumindest in der Höhenrichtung 5a keine oder zumindest keine nennenswerte Verformung erfährt.

Bei allen Ausführungsbeispielen ist der Kraftabgabeabschnitt 15 plattenförmig ausgebildet, wenngleich er prinzipiell jede beliebige Gestalt aufweisen kann. Die Formgebung des Kraftabgabeabschnittes 15 orientiert sich insbesondere am Einsatzzweck des Elastomer-Aktuators 1. Vorzugsweise besteht er aus einem über eine ausreichend hohe Struktursteifigkeit verfügenden Metall oder Kunststoffmaterial oder Verbundmaterial.

Mindestens einer und bevorzugt jeder der beiden Kraftabgabeabschnitte 15 ist mit mindestens einer nur gestrichelt angedeuteten Befestigungsschnittstelle 16 ausgestattet, die beispielsweise nutzbar ist, um eine zu bewegende und/oder kräftemäßig zu beaufschlagende externe Komponente zu fixieren. Die Befestigungsschnittstelle 16 kann beispielsweise ein Gewinde oder eine Öse aufweisen. Die Befestigungsschnittstelle 16 kann beispielsweise auch eine wie auch immer ausgebildete Befestigungsfläche sein, an der bei einer Nutzung des Elastomer-Aktuators 1 als Antriebseinheit eines Ventils ein Ventilglied, beispielsweise ein aus einem Elastomermaterial bestehendes Verschlusselement, anbringbar oder angebracht ist.

Der Elastomer-Aktuator 1 ist so ausgebildet, dass die Antriebsstruktur 2 die Antriebskraft in den Kraftabgabeabschnitt 15 nicht direkt einleitet, sondern nur mittelbar unter Zwischenschaltung einer besonderen Kraftübertragungsstruktur 17. Jedem Kraftabgabeabschnitt 15 ist zweckmäßigerweise eine solche Kraftübertragungsstruktur 17 zugeordnet. Die Kraftübertragungsstruktur 17 ist in der Höhenrichtung 5a zwischen die Antriebsstruktur 2 und den ihr jeweils mit Abstand vorgelagerten Kraftabgabeabschnitt 15 eingegliedert. Die Kraftübertragungsstruktur 17 liegt also axial zwischen einer Stirnseite 14a, 14b der Antriebsstruktur 2 und dem der betreffenden Stirnseite 14a, 14b vorgelagerten Kraftabgabeabschnitt 15. Die Besonderheit jeder Kraftübertragungsstruktur 17 besteht darin, dass sie über anisotrope Festigkeitseigenschaften verfügt, indem sie in der Höhenrichtung 5a der Antriebsstruktur 2 steif ist und in mindestens einer und vorzugsweise in jeder hierzu rechtwinkeligen Querrichtung 7a flexibel ist.

Bei den Ausführungsbeispielen ist der Elastomer-Aktuator 1 an beiden einander axial entgegengesetzten Endbereichen mit einer Kombination aus einem starren Kraftabgabeabschnitt 15 und einer in dem geschilderten Umfang festigkeitsmäßig anisotrop ausgebildeten Kraftübertragungsstruktur 17 ausgestattet. Bei einem nicht gezeigten Ausführungsbeispiel des Elastomer-Aktuators 1 ist nur einer der beiden Stirnseiten 14a oder 14b ein mit einer Kraftübertragungsstruktur 17 kombinierter Kraftabgabeabschnitt 15 vorgelagert, sodass zwar der vorteilhafte Effekt weniger ausgeprägt ist als bei der Doppelanordnung, gleichwohl jedoch auch hier im Vergleich zu konventionell gestalteten Elastomer-Aktuatoren 1 Leistungsvorteile erzielt werden.

Jeder Kraftabgabeabschnitt 15 stützt sich in der Höhenrichtung 5a an der benachbarten Kraftübertragungsstruktur 17 ab, die sich ihrerseits an der an der betreffenden Stirnseite 14a, 14b vorhandenen Stirnfläche 18a, 18b der Antriebsstruktur 2 abstützt. Allen Ausführungsbeispielen ist gemeinsam, dass die Kraftübertragungsstruktur 17 an der zugewandten Stirnfläche 18a, 18b der Antriebsstruktur 2 nur kraftschlüssig anliegt, sodass keine feste Verbindung gegeben ist, sondern man von einer losen Anlage sprechen kann. Vorzugsweise liegt auch in keiner Querrichtung 7a ein Formschluss vor. Die kraftschlüssige Anlage hat gleichwohl aufgrund der damit einhergehenden Reibungskraft den Effekt, dass bei einer Quer-Verformung 13 der Antriebsstruktur 2, die auch eine Vergrößerung der jeweiligen Stirnfläche 18a, 18b zur Folge hat, die Kraftübertragungsstruktur 17 von der an ihr anliegenden Stirnfläche 18a, 18b mitgenommen wird, sodass sie zumindest bereichsweise eine Querbewegung 22 in zu der Höhenrichtung 5a rechtwinkeliger Richtung ausführt, und zwar relativ zu dem in der Querrichtung 7a seine Position und seine Gestalt beibehaltenden Kraftabgabeabschnitt 15.

Die Quernachgiebigkeit der Kraftübertragungsstruktur 17 in zumindest den unmittelbar benachbart zur Antriebsstruktur 2 angeordneten Bereichen sorgt dafür, dass das Querverformungsvermögen der Antriebsstruktur 2 durch die sie beaufschlagende Kraftübertragungsstruktur 17 erheblich weniger stark beeinträchtigt ist, als wenn die Kraftübertragungsstruktur 17 ein in der Querrichtung 7a steifes Gebilde wäre oder als wenn der starre Kraftabgabeabschnitt 15 unmittelbar an der Stirnfläche 18a, 18b anliegen würde.

In dem zu den beiden Stirnflächen 18a, 18b beabstandeten Mittelabschnitt ist die Antriebsstruktur 2 aufgrund ihrer Flexibilität von Hause aus in der Lage, relativ große Quer-Verformungen 13 auszuführen. Durch die spezielle Ausgestaltung der Kraftübertragungsstruktur 17 ist nun gewährleistet, dass dieses gute Quer-Verformungsvermögen auch im Bereich der beiden stirnseitigen Endabschnitte der Antriebsstruktur 2 vorliegt.

Da sich das Quer-Verformungsvermögen der Antriebsstruktur 2 unmittelbar auf das Haupt-Verformungsvermögen in der Höhenrichtung 5a auswirkt, erreicht man mit der speziellen Gestaltung der Kraftübertragungsstruktur 17 bei gleicher Ansteuerspannung eine größere Haupt-Verformung 12. Es besteht daher die Möglichkeit, einen Elastomer-Aktuator 1 im Vergleich zu konventionellen Bauformen zur Erzielung des gleichen Ergebnisses mit einer geringeren Ansteuerspannung zu betreiben und/oder mit einer weniger hohen und deshalb auch kostengünstiger herstellbaren Antriebsstruktur 2 auszustatten.

Allen Ausführungsbeispielen des Elastomer-Aktuators 1 ist in vorteilhafter Weise gemeinsam, dass die Kraftübertragungsstruktur 17 in jeder Querrichtung 7a über flexible Eigenschaften verfügt, also eine isotrope Nachgiebigkeit in einer zur Höhenrichtung 5a der Antriebsstruktur 2 rechtwinkeligen Querebene 23 hat.

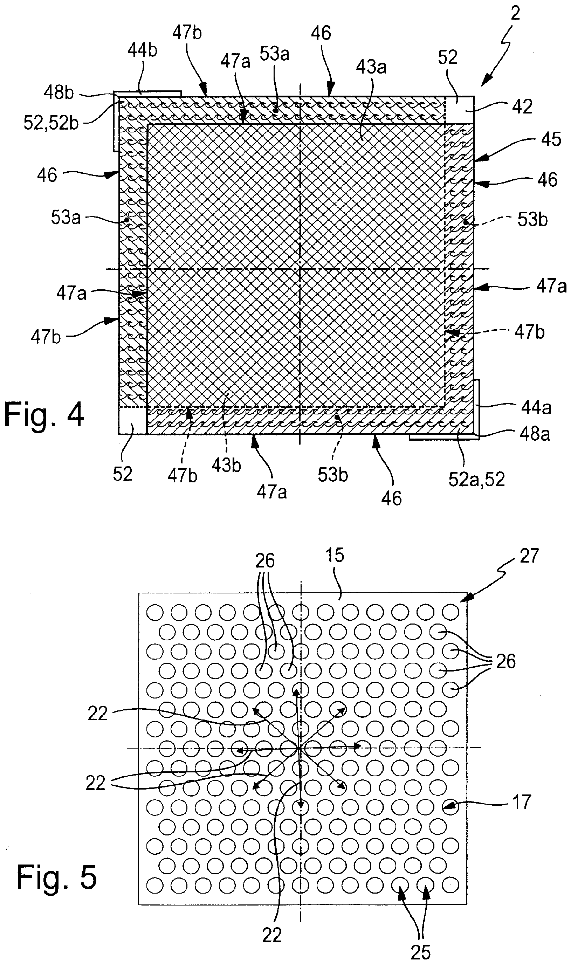

Bei dem Ausführungsbeispiel der Figuren 1 bis 9 wird dies dadurch erreicht, dass sich die Kraftübertragungsstruktur 17 aus einer Vielzahl länglicher Stützelemente 24 zusammensetzt, die sich jeweils zumindest im Wesentlichen in der Höhenrichtung 5a erstrecken und die in einer zu der Höhenrichtung 5a rechtwinkeligen Querebene 23 eine flächenhafte dichte Verteilung aufweisen, die insbesondere auch in Figur 5 zum Ausdruck kommt. Zweckmäßigerweise liegen die Stützelemente 24 jedoch nicht aneinander an. Die länglichen Stützelemente 24 stützen sich einerseits mit einer vorderen Stirnseite 25 an der zugewandten Stirnfläche 18a, 18b der Antriebsstruktur 2 ab, während sie sich andererseits mit ihrem entgegengesetzten rückwärtigen Endabschnitt 26 am zugeordneten Kraftabgabeabschnitt 15 abstützen. Die Abstützung erfolgt jeweils in der Höhenrichtung 5a.

Die länglichen Stützelemente 24 sind in ihrer axialen Richtung sehr drucksteif und neigen auch bei erhöhter axialer Belastung nicht zum Ausknicken. Andererseits sind sie aber in sich quer zu ihrer Längsrichtung flexibel beziehungsweise biegbar, wobei sie insbesondere über ein elastisch reversibles Biegeverhalten verfügen.

An den rückwärtigen Endabschnitten 26 sind die länglichen Stützelemente 24 zweckmäßigerweise ortsfest an dem Kraftabgabeabschnitt 15 fixiert. Denkbar wäre in diesem Zusammenhang eine bezüglich des Kraftabgabeabschnittes 15 separate Ausgestaltung der länglichen Stützelemente 24 in Verbindung mit einer Klebeverbindung und/oder Schweißverbindung zum Erhalt eines einheitlich handhabbaren Kraftabgabekörpers 27, der in sich einen Kraftabgabeabschnitt 15 und die zugeordnete Kraftübertragungsstruktur 17 vereinigt. Beim Ausführungsbeispiel der Figuren 1 bis 9 ist der Kraftabgabekörper 27 insgesamt einstückig ausgebildet, wobei die länglichen Stützelemente 24 an ihren rückwärtigen Endabschnitten 26 einstückig mit dem Kraftabgabeabschnitt 15 verbunden sind. Der Kraftabgabekörper 27 kann hier in seinem Aufbau insbesondere mit demjenigen einer Bürste verglichen werden.

Die Querbewegung 22 der Kraftübertragungsstruktur 17 äußert sich in diesem Fall darin, dass die länglichen Stützelemente 24 an ihren mit dem Kraftabgabeabschnitt 15 fest verbundenen Endabschnitt 26 keine Querbewegung 22 ausführen, mit zunehmendem Abstand zum Kraftabgabeabschnitt 15 jedoch eine Querbewegung 22 auftritt, deren Auslenkung im unmittelbaren Kontaktbereich zur Antriebsstruktur 2 am größten ist.

Da die länglichen Stützelemente 24 in der Querebene 23 allseits auslenkbar sind, können sie problemlos der Verformungsrichtung der Antriebsstruktur 2 folgen, die im unmittelbaren Kontaktbereich zwischen jedem Stützelement 24 und der Antriebsstruktur 2 gegeben ist.

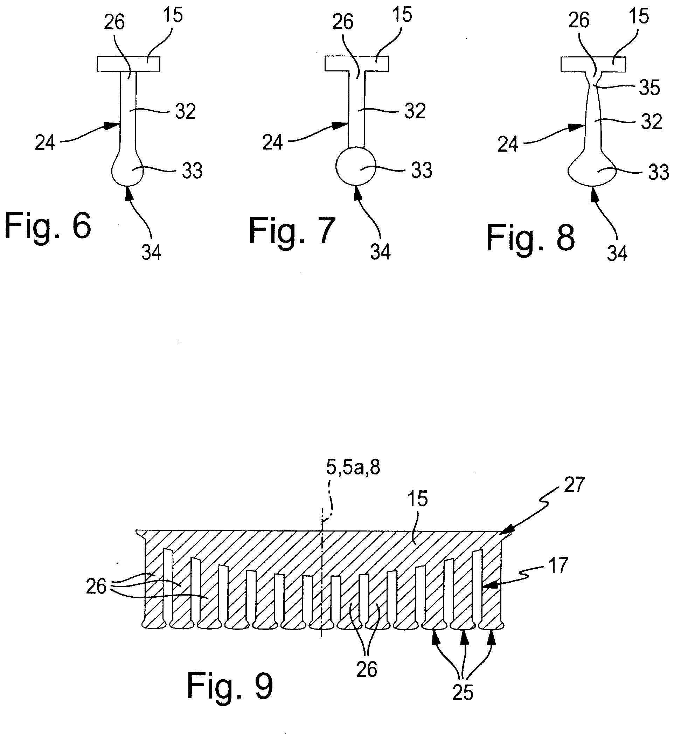

Die länglichen Stützelemente 24 können, was aus Figuren 1 bis 8 hervorgeht, untereinander die gleiche Länge haben. Da jedoch die Quer-Verformung 13 der Antriebsstruktur 2 mit zunehmendem Abstand zum zentralen Bereich der Antriebsstruktur 2 zunimmt, ist es vorteilhaft, die Kraftübertragungsstruktur 17 so zu gestalten, dass die axiale Länge der Stützelemente 24 mit zunehmendem Abstand zum zentralen Bereich der Antriebsstruktur 2 größer wird. Eine solche Ausführungsform ist in Figur 9 illustriert.

Für den notwendigen axialen Zusammenhalt in der Höhenrichtung 5a der einzelnen Komponenten des Elastomer-Aktuators 1 sorgen beispielsweise elastische Spannmittel 28, die in Figuren 1 und 2 gestrichelt angedeutet sind. Diese elastischen Spannmittel 28 halten die Antriebsstruktur 2, den mindestens einen Kraftabgabeabschnitt 15 und die mindestens eine Kraftübertragungsstruktur 17 in der Höhenrichtung 5a und vorzugsweise auch in der Querrichtung dazu zusammen, insbesondere durch Auferlegung einer elastischen Spannkraft. Die elastischen Spannmittel 28 sorgen auch dafür, dass die länglichen Stützelemente 24 mit ihrer vorderen Stirnseite 25 fest an die Antriebsstruktur 2 angedrückt werden.

Beim Ausführungsbeispiel sind die elastischen Spannmittel 28 in Form eines gummielastischen Hüllkörpers 28a realisiert, der die zusammenzuhaltenden Komponenten 2, 15, 17 außen zumindest partiell umschließt. Beim Ausführungsbeispiel sind lediglich die Befestigungsschnittstellen 16 und die hierzu benachbarten Bereiche der Kraftabgabeabschnitte 15 durch den Hüllkörper 28a unabgedeckt. Der Hüllkörper 28a ist beispielsweise eine Folie aus einem hochelastischen Elastomermaterial.

Bevorzugt ist der Hüllkörper 28a schlauchförmig ausgebildet und nach Art eines Schrumpfschlauches auf den zusammenzuhaltenden Komponenten 2, 15, 17 fixiert.

Aufgrund der Elastizität der Spannmittel 28 können diese den Zusammenhalt der Komponenten des Elastomer-Aktuators 1 unabhängig vom momentanen Verformungszustand gewährleisten.

Während die aus Figuren 1, 2 und 5 ersichtlichen länglichen Stützelemente 24 stabförmig mit über ihre Länge hinweg zweckmäßigerweise konstantem Querschnitt ausgeführt sind, machen die Figuren 6 bis 8 deutlich, dass auch abweichende Formgebungen länglicher Stützelemente 24 möglich sind. Allen hier illustrierten länglichen Stützelementen 24 ist gemeinsam, dass sie einen stabförmigen oder drahtförmigen länglichen Stützabschnitt 32 haben, der an einem rückwärtigen Endabschnitt 26 am Kraftabgabeabschnitt 15 fixiert ist und an dessen entgegengesetztem vorderen Endbereich sich ein vorderer verdickter Endabschnitt 33 anschließt.

Die Verdickung hat den Vorteil, dass sich die länglichen Stützelemente 24 nicht zu sehr in die elastische Antriebsstruktur 2 eindrücken. Denkbar sind hier beispielsweise tropfenförmig verdickte Endabschnitte 33 gemäß Figur 6 oder auch kugelförmig verdickte Endabschnitte gemäß Figur 7. Jeder verdickte Endabschnitt 33 hat zweckmäßigerweise eine kugelkappenförmig abgerundete vordere Stirnfläche 34, mit der er sich bei der Querverformung der Antriebsstruktur 2 an der zugewandten Stirnfläche 18a, 18b der Antriebsstruktur 2 abwälzen kann.

Aus der Figur 8 ist ersichtlich, dass die stabförmigen länglichen Stützelemente 24 mindestens eine und vorzugsweise genau eine Einschnürung 35 aufweisen können, die ein Festkörpergelenk definiert und die die Querflexibilität beziehungsweise Querbeweglichkeit verbessert. Die Einschnürung 35 befindet sich zweckmäßigerweise im Bereich des rückwärtigen Endabschnittes 26 des betreffenden Stützelementes 24.

Es besteht durchaus die Möglichkeit, eine feste Verbindung zwischen der Kraftübertragungsstruktur 17 und der Antriebsstruktur 2 vorzusehen. Beispielsweise könnte die Kraftübertragungsstruktur 17 in den Kontaktbereichen zur Antriebsstruktur 2 mit der Antriebsstruktur 2 verklebt oder verschweißt sein.

Die Figuren 10 und 11 zeigen ein Ausführungsbeispiel des Elastomer-Aktuators 1, bei dem die Kraftübertragungsstruktur 17 jeweils separat bezüglich des zugeordneten Kraftabgabeabschnittes 15 ausgebildet ist.

Konkret besteht hier die Kraftübertragungsstruktur 17 aus einer Vielzahl von Stützelementen, die in Form von Wälzelementen 36 ausgebildet sind, die zwischen den Kraftabgabeabschnitt 15 und die Antriebsstruktur 2 eingegliedert sind. Es handelt sich um eine Vielzahl von Wälzelementen 36, die mit möglichst geringem Abstand zueinander großflächig über die zugeordnete Stirnfläche 18a, 18b der Antriebsstruktur 2 verteilt sind. Die Wälzelemente 36 liegen einerseits an der jeweils zugeordneten Stirnfläche 18a, 18b der Antriebsstruktur 2 an und andererseits an einer dieser Stirnfläche 18a, 18b zugewandten Abstützfläche 37 des zugeordneten Kraftabgabeabschnittes 15. Die Abstützfläche 37 ist zweckmäßigerweise eine ebene Fläche mit einer Erstreckung rechtwinkelig zur Hochachse 5, wie dies insbesondere auch auf die Stirnflächen 18a, 18b zutrifft.

Findet aufgrund einer Haupt-Verformung 12 eine Quer-Verformung 13 der Antriebsstruktur 2 statt, wälzen sich die Wälzelemente 36 jeweils sowohl an der zugewandten Stirnfläche 18a, 18b der Antriebsstruktur 2 als auch an der Abstützfläche 37 des zugeordneten Kraftabgabeabschnittes 15 ab, wobei sie eine Querbewegung 22 ausführen, sodass sich der zwischen ihnen befindliche Abstand verändert. Die Flexibilität der Kraftübertragungsstruktur 17 resultiert hier also aus der relativen Querbeweglichkeit zwischen den Wälzelementen 36 und dem Kraftabgabeabschnitt 15.

Die Abstützfläche 37 ist zweckmäßigerweise von der Grundfläche einer randseitig ringsum begrenzten Ausnehmung 38 des Kraftabgabeabschnittes 15 gebildet, sodass eine Sicherheit gegen ein versehentliches Herausfallen der Wälzelemente 36 gegeben ist. Im Übrigen gilt für das Ausführungsbeispiel der Figuren 10 und 11 das in Bezug auf die Spannmittel 28 zum anderen Ausführungsbeispiel Gesagte entsprechend.

Auch beim Ausführungsbeispiel der Figuren 10 und 11 besteht die Möglichkeit, den Kraftabgabeabschnitt 15 und die die Wälzelemente 36 aufweisende Kraftübertragungsstruktur 17 in einem einheitlich handhabbaren Kraftabgabekörper zu vereinigen. Dies geschieht beispielsweise dadurch, dass die Wälzelemente 36 in eine elastisch verformbare Käfigstruktur eingegliedert werden, die an dem Kraftabgabeabschnitt 15 befestigt ist.

Um trotz kompakter Abmessungen große Haupt-Verformungen 12 zu erzielen, ist es vorteilhaft, wenn die Antriebsstruktur 2 einen in der Höhenrichtung 5a mehrschichtigen Aufbau hat. Ein solcher Aufbau ist bei den beiden Ausführungsbeispielen gegeben, worauf nachstehend näher eingegangen wird.

Die Elastomerstruktur 3 enthält zweckmäßigerweise eine Mehrzahl von in der Höhenrichtung 5a aufeinandergestapelten, bevorzugt plattenförmigen Elastomermaterialschichten 42, also Schichten aus Elastomermaterial. Diese Elastomermaterialschichten 42 sind bevorzugt folienartig dünn und in der Zeichnung der besseren Übersichtlichkeit wegen vergrößert abgebildet. Jede Elastomermaterialschicht 42 erstreckt sich zweckmäßigerweise in einer zu der Querebene 23 parallelen Hauptausdehnungsebene.

Die Stapelung der Elastomermaterialschichten 42 ist abwechselnd mit zu der Elektrodenstruktur 4 gehörenden ersten und zweiten Elektrodenschichten 43a, 43b realisiert. Zwischen zwei in der Höhenrichtung 5a unmittelbar aufeinanderfolgenden Elastomermaterialschichten 42 liegt jeweils eine erste oder zweite Elektrodenschicht 43a, 43b. Eine weitere Elektrodenschicht 43a, 43b befindet sich an der in der Höhenrichtung 5a der Kraftübertragungsstruktur 17 zugewandten äußeren Stirnfläche einer jeden der beiden die Elastomerstruktur 3 stirnseitig abschließenden Elastomermaterialschichten 42.

Somit ist jede Elastomermaterialschicht 42 an ihren in der Höhenrichtung 5a einander entgegengesetzten Seiten auf der einen Seite von einer ersten Elektrodenschicht 43a und auf der anderen Seite von einer zweiten Elektrodenschicht 43b flankiert.

Die Elektrodenschichten 43 sind wie die Elastomermaterialschichten 42 elastisch verformbar und bestehen beispielsweise aus einer beim Herstellungsprozess aufgetragenen Graphitschicht.

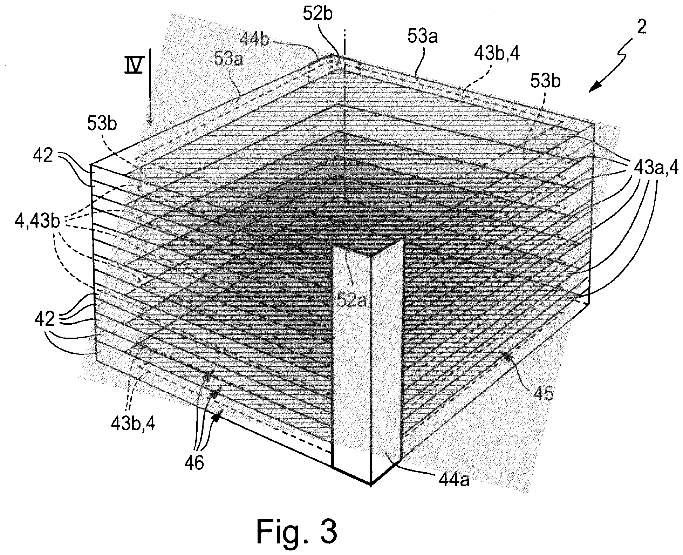

Die Elektrodenschichten 43a, 43b sind wechselseitig an zwei streifenförmige Verbindungsleiter 44a, 44b elektrisch leitend angeschlossen, die sich, was insbesondere aus Figuren 3 und 4 hervorgeht, außen an der rechtwinkelig zur Höhenrichtung 5a weisenden Mantelfläche 45 der Antriebsstruktur 2 befinden. Alle ersten Elektrodenschichten 43a sind mit dem einen, ersten Verbindungsleiter 44a kontaktiert, alle zweiten Elektrodenschichten 43b sind mit dem anderen, zweiten Verbindungsleiter 44b kontaktiert.

Ein erster (6a) der oben erwähnten Anschlussleiter 6a, 6b steht mit der Gruppe erster Elektrodenschichten 43a in elektrisch leitender Verbindung. Ein zweiter (6b) der oben erwähnten Anschlussleiter 6a, 6b ist elektrisch leitend mit der Gruppe zweiter Elektrodenschichten 43b kontaktiert. Auf diese Weise besteht die Möglichkeit, die beiden Gruppen von Elektrodenschichten 43a, 43b gleichzeitig zu bestromen, sodass sich zwischen jedem Paar zueinander benachbarter erster und zweiter Elektrodenschichten 43a, 43b ein elektrisches Feld ausbildet, das die betreffenden Elektrodenschichten 43a, 43b in der Höhenrichtung 5a zueinander zieht. Dies führt zu einer Komprimierung der Elastomermaterialschichten 42 in der Höhenrichtung 5a, das heißt rechtwinkelig zu ihrer Hauptausdehnungsebene, was insgesamt zu der Haupt-Verformung 12 führt. Gleichzeitig erfährt aber auch jede Elastomermaterialschicht 42 eine Materialdehnung rechtwinkelig zu der Höhenrichtung 5a, was zu der Quer-Verformung 13 führt.

Die Gruppen erster und zweiter Elektrodenschichten 43a, 43b können unmittelbar an den beiden Verbindungsleitern 44a, 44b elektrisch kontaktiert werden. Beim Ausführungsbeispiel der Figuren 10 und 11 ist jeder der beiden Anschlussleiter 6a, 6b mit einem der beiden Verbindungsleiter 44a, 44b elektrisch kontaktiert.

Eine aus Figuren 1 und 2 ersichtliche weitere Art einer vorteilhaften elektrischen Kontaktierung sieht vor, dass die Ansteuerspannung an die beiden Kraftabgabeabschnitte 15 anlegbar ist, wobei jeder Kraftabgabeabschnitt 15 unter Vermittlung der zugeordneten Kraftübertragungsstruktur 17 elektrisch leitend mit der auch als End-Elektrodenschicht bezeichenbaren äußeren Elektrodenschicht 43a, 43b verbunden ist, die an einer der beiden Stirnseiten 14a, 14b der Antriebsstruktur 2 platziert ist. In diesem Fall ist die von der Kraftübertragungsstruktur 17 beaufschlagte Stirnfläche 18a, 18b der Antriebsstruktur 2 zumindest teilweise unmittelbar von der Fläche der zugeordneten äußeren Elektrodenschicht 43a, 43b gebildet.

Bei diesem Ausführungsbeispiel sind die Anschlussleiter 6a, 6b zum Anlegen der Ansteuerspannung zweckmäßigerweise mit den beiden Kraftabgabeabschnitten 15 kontaktiert, die zu diesem Zweck über nicht weiter illustrierte Steckanschlussmittel verfügen können.

Es versteht sich, dass in diesem Zusammenhang der Kraftabgabeabschnitt 15 und die zugeordnete Kraftübertragungsstruktur 17 entweder insgesamt aus einem elektrisch leitenden Material bestehen, beispielsweise aus Metall, oder ganz oder teilweise metallisiert oder auf andere Weise elektrisch leitend beschichtet sind, um den erforderlichen Stromfluss zu gewährleisten.

Vor allem die Figuren 3 und 4 illustrieren eine Antriebsstruktur 2, die einen besonders vorteilhaften Aufbau hat, weil sie es ermöglicht, ohne erhöhte Kurzschlussgefahr auf Elektrodenschichten 43a, 43b zurückzugreifen, die über eine relativ große Grundfläche verfügen.

Bei dieser Ausführungsform haben die Elastomermaterialschichten 42, was zweckmäßigerweise für alle Ausführungsbeispiele zutrifft, in einem zur Hochachse 5 rechtwinkeligen Querschnitt der Antriebsstruktur 2 betrachtet, einen rechteckigen Umriss. Vorzugsweise handelt es sich dabei um einen quadratischen Umriss. Jede Elastomermaterialschicht 42 hat vier in der Umfangsrichtung rings um die Hochachse 5 herum aneinander angrenzende Randflächen 46, die jeweils in einem Eckbereich 52 rechtwinkelig ineinander übergehen.

Auch die Elektrodenschichten 43a, 43b sind rechteckig und insbesondere quadratisch konturiert, wobei sie jeweils über vier sich jeweils unmittelbar aneinander anschließende und in jeweils einem Eckbereich rechtwinkelig ineinander übergehende Außenränder 47a, 47b verfügen.

Die Grundfläche jeder Elektrodenschicht 43a, 43b ist kleiner als diejenige jeder Elastomermaterialschicht 42. Außerdem sind die Elektrodenschichten 43a, 43b so platziert, dass sie in der Höhenrichtung 5a abwechselnd einander diagonal gegenüberliegenden Eckbereichen 52, 52a, 52b der Elastomermaterialschichten 42 zugeordnet sind.

Jede Elastomermaterialschicht 42 hat einen ersten Eckbereich 52, 52a und einen diesem ersten Eckbereich 52, 52a diagonal gegenüberliegenden zweiten Eckbereich 52, 52b. Die ersten Elektrodenschichten 43a sind nun so platziert, dass diejenigen beiden ihrer Außenränder 47a, die in einem ersten Eckbereich 48a winkelig aneinander angrenzen, flächenbündig mit den am ersten Eckbereich 52a aufeinandertreffenden Randflächen 46 der Elastomermaterialschichten 42 verlaufen. In entsprechender Weise sind die zweiten Elektrodenschichten 43b ebenfalls außermittig bezüglich der Elastomermaterialschichten 42 platziert, und zwar derart, dass sie mit einem als zweiter Eckbereich 48b bezeichneten Eckbereich derart im Bereich der zweiten Eckbereiche 52b der Elastomermaterialschichten 42 platziert sind, dass ihre dort winkelig aufeinandertreffenden Außenränder 47b mit den zugeordneten seitlichen Randflächen 46 der Elastomermaterialschichten 42 bündig verlaufen.

Als Resultat ist jede Elektrodenschicht 43a, 43b derart quer zur Höhenrichtung 5a versetzt zu den Elastomermaterialschichten 42 angeordnet, dass sich zwischen den anderen Randflächen 46 der Elastomermaterialschichten 42 und den diesbezüglich abgerückten Außenrändern 47a, 47b der Elastomermaterialschichten 43 jeweils eine in ihrer Längsrichtung abgewinkelte und bevorzugt L-förmig verlaufende streifenförmige Randfläche ergibt, die als Isolierrandfläche 53a beziehungsweise 53b bezeichnet sei. In Figur 4 sind die Isolierrandflächen 53a, 53b zur Verdeutlichung mit einem Wellenmuster hinterlegt.

In der Höhenrichtung 5a ergeben sich dadurch abwechselnd in Richtung zu dem einen Eckbereich 52a und in Richtung zum anderen Eckbereich 52b versetzt zueinander angeordnete Elektrodenschichten 43a, 43b, die jeweils an den vom Rand der Elastomermaterialschichten 42 abgerückten Außenrändern 47a, 47b von einer Isolierrandfläche 53a, 53b umrandet sind, in deren Bereich sich keine Elektrode befindet.

Durch die Isolierrandflächen 53a, 53b wird erreicht, dass bei der Aktivierung des Elastomer-Aktuators 1 auf unterschiedlichem Potential liegende erste und zweite Elektrodenschichten 43a, 43b mit einem relativ großen Abstand zueinander angeordnet sind, sodass auch bei hohen Ansteuerspannungen ein Funkenüberschlag und folglich ein Kurzschluss vermieden werden kann.

Der die ersten Elektrodenschichten 43a auf das gleiche Potential legende Verbindungsleiter 44a ist in demjenigen Umfangsbereich der Mantelfläche 45 angeordnet, in dem die ersten Elektrodenschichten 43a mit der Mantelfläche 45 bündig verlaufen. Entsprechendes gilt für die zweiten Verbindungsleiter 44b bezüglich ihrer Anordnung zur Verbindung der zweiten Elektrodenschichten 43b. Als besonders vorteilhaft wird es angesehen, wenn die Verbindungsleiter 44a, 44b denjenigen beiden Eckbereichen 52a, 52b der Elastomermaterialschichten 42 zugeordnet sind, zu denen hin die Elektrodenschichten 43a, 43b versetzt sind. Dabei ist es vorteilhaft, wenn die Verbindungsleiter 44a, 44b ein abgewinkeltes Querschnittsprofil haben, sodass sie jeweils einen streifenförmigen Abschnitt beider im betreffenden Eckbereich 52a, 52b aneinander angrenzender Randflächen 46 der Elastomermaterialschichten 42 bedecken.

Das geschilderte Anordnungsprinzip der Elektrodenschichten 43a, 43b lässt sich auch bei nicht rechteckig konturierten Antriebsstrukturen 2 anwenden. Letztlich kommt es maßgeblich nur darauf an, dass die Grundflächen der Elektrodenschichten 43a, 43b kleiner sind als die Grundflächen der Elastomermaterialschichten 42 und dass die Elektrodenschichten 43a, 43b abwechselnd zu einander gegenüberliegenden Randbereichen der Elastomermaterialschichten 42 versetzt sind, sodass sie partiell von einer Isolierrandfläche 53a, 53b umrahmt sind, die das Kurzschlussrisiko herabsetzt.

## Patentansprüche

1. Elastomer-Aktuator, mit einer zumindest partiell über elastomere Eigenschaften verfügenden Antriebsstruktur (2), die eine in einer Höhenrichtung (5a) verlaufende Hochachse (5) aufweist und die bei elektrischer und/oder magnetischer Aktivierung eine Haupt-Verformung (12) in der Höhenrichtung (5a) erfährt und dabei aufgrund überlagerter Materialdehnungen rechtwinkelig zu der Höhenrichtung (5a) ihre Querabmessungen verändert, wobei an wenigstens einer Stirnseite (14a, 14b) der Antriebsstruktur (2) ein im Vergleich zu der Antriebsstruktur (2) starrer Kraftabgabeabschnitt (15) angeordnet ist und wobei zwischen dem Kraftabgabeabschnitt (15) und der Antriebsstruktur (2) eine über anisotrope Festigkeitseigenschaften verfügende, in der Höhenrichtung (5a) steif und in dazu rechtwinkeliger Richtung flexibel ausgebildete Kraftübertragungsstruktur (17) angeordnet ist, **dadurch gekennzeichnet, dass** die Kraftübertragungsstruktur (17) separat bezüglich des Kraftabgabeabschnittes (15) ausgebildet ist, wobei sie über eine Mehrzahl von als Stützelemente fungierenden Wälzelementen (36) verfügt, die zwischen dem Kraftabgabeabschnitt (15) und der Antriebsstruktur (2) angeordnet sind und die sich bei Querdehnungen der Antriebsstruktur (2) sowohl an dem Kraftabgabeabschnitt (15) als auch an der Antriebsstruktur (2) abwälzen können.

2. Elastomer-Aktuator nach Anspruch 1, **dadurch gekennzeichnet, dass** die Wälzelemente (36) kugelförmig ausgebildet sind.

3. Elastomer-Aktuator, mit einer zumindest partiell über elastomere Eigenschaften verfügenden Antriebsstruktur (2), die eine in einer Höhenrichtung (5a) verlaufende Hochachse (5) aufweist und die bei elektrischer und/oder magnetischer Aktivierung eine Haupt-Verformung (12) in der Höhenrichtung (5a) erfährt und dabei aufgrund überlagerter Materialdehnungen rechtwinkelig zu der Höhenrichtung (5a) ihre Querabmessungen verändert, wobei an wenigstens einer Stirnseite (14a, 14b) der Antriebsstruktur (2) ein im Vergleich zu der Antriebsstruktur (2) starrer Kraftabgabeabschnitt (15) angeordnet ist und wobei zwischen dem Kraftabgabeabschnitt (15) und der Antriebsstruktur (2) eine über anisotrope Festigkeitseigenschaften verfügende, in der Höhenrichtung (5a) steif und in dazu rechtwinkeliger Richtung flexibel ausgebildete Kraftübertragungsstruktur (17) angeordnet ist, **dadurch gekennzeichnet, dass** die Kraftübertragungsstruktur (17) aus einer Vielzahl von länglichen Stützelementen (24) besteht, die sich jeweils mit einer Stirnseite (25) an der Antriebsstruktur (2) abstützen und die nach Art von Borsten einer Bürste verteilt angeordnet sind.

4. Elastomer-Aktuator nach Anspruch 3, **dadurch gekennzeichnet, dass** die länglichen Stützelemente (24) stabförmig ausgebildet sind.

5. Elastomer-Aktuator nach Anspruch 3 oder 4, **dadurch gekennzeichnet, dass** die länglichen Stützelemente (24) axial drucksteif und dabei quer zu ihrer Längsrichtung flexibel und insbesondere elastisch biegbar sind und/oder dass die länglichen Stützelemente (24) jeweils mindestens eine ein integrales Schwenkgelenk definierende Einschnürung (35) aufweisen.

6. Elastomer-Aktuator nach einem der Ansprüche 3 bis 5, **dadurch gekennzeichnet, dass** die länglichen Stützelemente (24) an ihrem der Antriebsstruktur (2) zugewandten Endbereich einen kugelförmig oder tropfenförmig verdickten Endabschnitt (33) haben, wobei die länglichen Stützelemente (24) zweckmäßigerweise eine ausgehend von einem mittleren Bereich der Kraftübertragungsstruktur (17) quer zu der Hochachse (5) nach außen hin zunehmende Länge haben.

7. Elastomer-Aktuator nach einem der Ansprüche 1 bis 6, **dadurch gekennzeichnet, dass** an beiden Stirnseiten (14a, 14b) der Antriebsstruktur (2) jeweils ein im Vergleich zu der Antriebsstruktur (2) starrer Kraftabgabeabschnitt (15) angeordnet ist, wobei zwischen jedem Kraftabgabeabschnitt (15) und der Antriebsstruktur (2) eine über anisotrope Festigkeitseigenschaften verfügende, in der Höhenrichtung (5a) steif und in dazu rechtwinkeliger Richtung flexibel ausgebildete Kraftübertragungsstruktur (17) angeordnet ist.

8. Elastomer-Aktuator nach einem der Ansprüche 1 bis 7, **dadurch gekennzeichnet, dass** er als ein dielektrischer elektroaktiver Elastomer-Aktuator (1) ausgebildet ist.

9. Elastomer-Aktuator nach einem der Ansprüche 1 bis 8, **dadurch gekennzeichnet, dass** die Antriebsstruktur (2) einen in der Höhenrichtung (5a) mehrschichtigen Aufbau hat und über mehrere in der Höhenrichtung (5a) aufeinandergestapelte Elastomermaterialschichten (42) verfügt, wobei zweckmäßigerweise zwischen in der Höhenrichtung (5a) benachbarten Elastomermaterialschichten (42) und zweckmäßigerweise auch an den in der Höhenrichtung (5a) orientierten äußeren Stirnflächen der beiden äußeren Elastomermaterialschichten (42) jeweils eine Elektrodenschicht (43a, 43b) angeordnet ist, an die zur elektrischen Aktivierung der Antriebsstruktur (2) eine Ansteuerspannung anlegbar ist.

10. Elastomer-Aktuator nach Anspruch 9, **dadurch gekennzeichnet, dass** die Elektrodenschichten (43a, 43b) wechselseitig an zwei streifenförmige Verbindungsleiter (44a, 44b) angeschlossen sind, die sich außen an der Mantelfläche (45) der Antriebsstruktur (2) befinden und sich in deren Höhenrichtung (5a) erstrecken.

11. Elastomer-Aktuator nach Anspruch 10, **dadurch gekennzeichnet, dass** die Elastomermaterialschichten (42) der Antriebsstruktur (2) in einem zu der Hochachse (5) rechtwinkeligen Querschnitt betrachtet einen rechteckigen Umriss haben und die Elektrodenschichten (43a, 43b) ebenfalls rechteckig konturiert sind, wobei die Elektrodenschichten (43a, 43b) eine kleinere Grundfläche haben als die Elastomermaterialschichten (42) und derart platziert sind, dass zwei aneinander angrenzende Außenränder (47a, 47b) ihrer vier Außenränder (47a, 47b) jeweils bündig mit zwei aneinander angrenzenden Randflächen (46) der vier äußeren Randflächen (46) der Elastomermaterialschichten (42) verlaufen, wobei die Elektrodenschichten (43a, 43b) wechselweise einander diagonal gegenüberliegenden Eckbereichen (52a, 52b) der Elastomermaterialschichten (42) zugeordnet sind und wobei die streifenförmigen Verbindungsleiter (44a, 44b) zweckmäßigerweise ebenfalls diesen beiden Eckbereichen (52a, 52b) zugeordnet sind.

12. Elastomer-Aktuator nach einem der Ansprüche 1 bis 11, **dadurch gekennzeichnet, dass** die Kraftübertragungsstruktur (17) in jeder zu der Höhenrichtung (5a) rechtwinkeligen Richtung über flexible Eigenschaften verfügt und/oder dass die Kraftübertragungsstruktur (17) an der Antriebsstruktur (2) kraftschlüssig anliegt.

13. Elastomer-Aktuator nach einem der Ansprüche 1 bis 12, **dadurch gekennzeichnet, dass** die Kraftübertragungsstruktur (17) und der Kraftabgabeabschnitt (15) unter Bildung eines Kraftabgabekörpers (27) fest und insbesondere einstückig miteinander verbunden sind.

14. Elastomer-Aktuator nach einem der Ansprüche 1 bis 13, **dadurch gekennzeichnet, dass** die Kraftübertragungsstruktur (17) und der Kraftabgabeabschnitt (15) zu einem einheitlich handhabbaren Kraftabgabekörper (27) vereinigt sind.

15. Elastomer-Aktuator nach einem der Ansprüche 1 bis 14, **dadurch gekennzeichnet, dass** er elastische Spannmittel (28) aufweist, die die Antriebsstruktur (2), den mindestens einen Kraftabgabeabschnitt (15) und die mindestens eine Kraftübertragungsstruktur (17) zu einer Baugruppe zusammenhalten und die zweckmäßigerweise von einem die zusammenzuhaltenden Komponenten (2, 15, 17) außen zumindest partiell umschließenden gummielastischen Hüllkörper (28a) gebildet sind.

16. Elastomer-Aktuator nach einem der Ansprüche 1 bis 15, **dadurch gekennzeichnet, dass** mindestens ein Kraftabgabeabschnitt (15) mindestens eine insbesondere zur Fixierung einer externen Komponente nutzbare Befestigungsschnittstelle (16) aufweist.

## Claims

1. Elastomer actuator, with a drive structure (2) having at least partly elastomeric properties, with a vertical axis (5) running in a vertical direction (5a) and which undergoes a main deformation (12) in the vertical direction (5a) during electrical and/or magnetic activation, and in so doing changes its lateral dimensions on account of superimposed material strains at right-angles to the vertical direction (5a), wherein there is provided on at least one end face (14a, 14b) of the drive structure (2) a force output section (15) which is rigid in comparison with the drive structure (2) and wherein there is provided between the force output section (15) and the drive structure (2) a force transmission structure (17) which has anisotropic strength properties, is rigid in the vertical direction (5a) and flexible in the direction at right-angles to the former, **characterised in that** the force transmission structure (17) is separate from the force output section (15), wherein it has a multiplicity of roller elements (36) acting as support elements, which are arranged between the force output section (15) and the drive structure (2) and, in the event of lateral strains of the drive structure (2), are able to roll on both the force output section (15) and also the drive structure (2).

2. Elastomer actuator according to claim 1, **characterised in that** the roller elements (36) are spherical in form.

3. Elastomer actuator, with a drive structure (2) having at least partly elastomeric properties, with a vertical axis (5) running in a vertical direction (5a) and which undergoes a main deformation (12) in the vertical direction (5a) during electrical and/or magnetic activation, and in so doing changes its lateral dimensions on account of superimposed material strains at right-angles to the vertical direction (5a), wherein there is provided on at least one end face (14a, 14b) of the drive structure (2) a force output section (15) which is rigid in comparison with the drive structure (2) and wherein there is provided between the force output section (15) and the drive structure (2) a force transmission structure (17) which has anisotropic strength properties, is rigid in the vertical direction (5a) and flexible in the direction at right-angles to the former, **characterised in that** the force transmission structure (17) is formed of a multiplicity of elongated support elements (24), each being supported on the drive structure (2) by one end face (25) and distributed like the bristles of a brush.

4. Elastomer actuator according to claim 3, **characterised in that** the elongated support elements (24) are rod-like in form.

5. Elastomer actuator according to claim 3 or 4, **characterised in that** the elongated support elements (24) are axially compression-stiff and at the same time flexible and in particular elastically flexible transversely to their axial direction, and/or that the elongated support elements (24) each has at least one constriction (35) defining an integral swivel joint.

6. Elastomer actuator according to any of claims 3 to 5, **characterised in that** the elongated support elements (24) have at their end section facing the drive structure (2) a spherical or drop-shaped thickened end section (33), wherein the elongated support elements (24) expediently have a length which increases outwards transversely to the vertical axis (5) from a central section of the force transmission structure (17).

7. Elastomer actuator according to any of claims 1 to 6, **characterised in that** there is provided on both end faces (14a, 14b) of the drive structure (2) in each case a force output section (15) which is rigid in comparison with the drive structure (2), wherein there is provided between each force output section (15) and the drive structure (2) a force transmission structure (17) which has anisotropic strength properties, is rigid in the vertical direction (5a) and flexible in the direction at right-angles to the former.

8. Elastomer actuator according to any of claims 1 to 7, **characterised in that** it is in the form of a dielectrically active elastomer actuator (1).

9. Elastomer actuator according to any of claims 1 to 8, **characterised in that** the drive structure (2) has a structure which is multi-layer in the vertical direction (5a) and has several elastomer material layers (42) stacked one above the other in the vertical direction (5a), wherein expediently between elastomer material layers (42) which are adjacent in the vertical direction (5a) and expediently also at the outer end faces, oriented in the vertical direction (5a), of the two outer elastomer material layers (42) there is provided in each case an electrode layer (43a, 43b), at which a drive voltage may be applied for electrical activation of the drive structure (2).

10. Elastomer actuator according to claim 9, **characterised in that** the electrode layers (43a, 43b) are connected alternately to two strip-like connecting leads (44a, 44b) which are located outside on the circumferential surface (45) of the drive structure (2) and extend in its vertical direction (5a).

11. Elastomer actuator according to claim 10, **characterised in that** the elastomer material layers (42) of the drive structure (2), viewed in a cross-section at right-angles to the vertical axis (5), have a rectangular contour and the electrode layers (43a, 43b) likewise have rectangular contours, wherein the electrode layers (43a, 43b) have a smaller footprint than the elastomer material layers (42) and are so placed that two adjoining outer edges (47a, 47b) of their four outer edges (47a, 47b) run in each case flush with two adjoining edge faces (46) of the four outer edge faces (46) of the elastomer material layers (42), wherein the electrode layers (43a, 43b) are alternately assigned diagonally opposite comer zones (52a, 52b) of the elastomer material layers (42) and wherein the strip-like connecting leads (44a, 44b) are expediently likewise assigned these two corner zones (52a, 52b).

12. Elastomer actuator according to any of claims 1 to 11, **characterised in that** the force transmission structure (17) has flexible properties in each direction at right-angles to the vertical direction (5a) and/or that the force transmission structure (17) makes force-fitting contact with the drive structure (2).

13. Elastomer actuator according to any of claims 1 to 12, **characterised in that** the force transmission structure (17) and the force output section (15) are connected permanently and in particular integrally to form a force output body (27).

14. Elastomer actuator according to any of claims 1 to 13, **characterised in that** the force transmission structure (17) and the force output section (15) are combined to form a single manageable force output body (27).

15. Elastomer actuator according to any of claims 1 to 14, **characterised in that** it has elastic clamping means (28) which hold together the drive structure (2), the force output section or sections (15) and the force transmission structure or structures (17) to form an assembly, and which are expediently formed by a rubber-elastic enveloping body (28a) which expediently encompasses at least partly from the outside the components (2, 15, 17) to be held together.

16. Elastomer actuator according to any of claims 1 to 15, **characterised in that** at least one force output section (15) has at least one mounting interface (16) which may be used in particular for fixing an external component.

## Revendications

1. Actionneur élastomère, avec une structure d'entraînement (2) disposant au moins partiellement de propriétés élastomères, qui présente un axe vertical (5) dans un sens de la hauteur (5a) et qui subit une déformation principale (12) dans le sens de la hauteur (5a) en cas d'activation électrique et/ou magnétique, et qui modifie alors ses dimensions transversales sur la base d'extensions de matières superposées perpendiculairement au sens de la hauteur (5a), dans lequel une section de libération des forces (15) fixe par rapport à la structure d'entraînement (2) est disposée sur au moins une face frontale (14a, 14b) de la structure d'entraînement (2) et dans lequel une structure de transmission des forces (17) disposant de propriétés de résistance anisotrope, rigide dans le sens de la hauteur (5a) et flexible dans le sens perpendiculaire à celui-ci est disposée entre la section de libération des forces (15) et la structure d'entraînement (2), **caractérisé en ce que** la structure de transmission des forces (17) est séparée de la section de libération des forces (15), dans lequel elle dispose d'une multitude d'éléments roulants (36) faisant office d'éléments d'appui, placés entre la section de libération des forces (15) et la structure d'entraînement (2) et pouvant rouler aussi bien sur la section de libération des forces (15) que la structure d'entraînement (2) en cas d'extensions transversales de la structure d'entraînement (2).

2. Actionneur élastomère selon la revendication 1, **caractérisé en ce que** les éléments roulants (36) sont de forme sphérique.

3. Actionneur élastomère, avec une structure d'entraînement (2) disposant au moins partiellement de propriétés élastomères, qui présente un axe vertical (5) dans un sens de la hauteur (5a) et qui subit une déformation principale (12) dans le sens de la hauteur (5a) en cas d'activation électrique et/ou magnétique, et qui modifie alors ses dimensions transversales sur la base d'extensions de matières superposées perpendiculairement au sens de la hauteur (5a), dans lequel une section de libération des forces (15) fixe par rapport à la structure d'entraînement (2) est disposée sur au moins une face frontale (14a, 14b) de la structure d'entraînement (2) et dans lequel une structure de transmission des forces (17) disposant de propriétés de résistance anisotrope, rigide dans le sens de la hauteur (5a) et flexible dans le sens perpendiculaire à celui-ci est disposée entre la section de libération des forces (15) et la structure d'entraînement (2), **caractérisé en ce que** la structure de transmission des forces (17) se compose d'une multitude d'éléments d'appui longitudinaux (24) qui s'appuient respectivement avec une face frontale (25) sur la structure d'entraînement (2) et qui sont répartis d'après le type de poils d'une brosse.

4. Actionneur élastomère selon la revendication 3, **caractérisé en ce que** les éléments d'appui longitudinaux (24) sont en forme de barre.

5. Actionneur élastomère selon la revendication 3 ou 4, **caractérisé en ce que** les éléments d'appui longitudinaux (24) sont rigides à la pression axialement et alors flexibles transversalement à leur sens longitudinal et notamment déformables élastiquement et/ou **en ce que** les éléments d'appui longitudinaux (24) présentent respectivement au moins un étranglement (35) définissant une articulation pivotante intégrée.

6. Actionneur élastomère selon l'une des revendications 3 à 5, **caractérisé en ce que** les éléments d'appui longitudinaux (24) ont une section terminale (33) épaissie en forme de sphère ou de goutte dans leur zone terminale faisant face à la structure d'entraînement (2), dans lequel les éléments d'appui longitudinaux (24) ont alors utilement une longueur croissante en direction de l'extérieur transversalement par rapport à l'axe vertical (5) en partant d'une zone médiane de la structure de transmission des forces (17).

7. Actionneur élastomère selon l'une des revendications 1 à 6, **caractérisé en ce qu'**une section de libération des forces (15) rigide par rapport à la structure d'entraînement (2) est disposée sur les deux faces frontales (14a, 14b) de la structure d'entraînement (2), dans lequel une structure de transmission des forces (17) disposant de propriétés de résistance anisotrope, rigide dans le sens de la hauteur (5a) et flexible dans le sens perpendiculaire à celui-ci est disposée entre chaque section de libération des forces (15) et la structure d'entraînement (2).

8. Actionneur élastomère selon l'une des revendications 1 à 7, **caractérisé en ce qu'**il prend la configuration d'un actionneur élastomère diélectrique actif électriquement (1).

9. Actionneur élastomère selon l'une des revendications 1 à 8, **caractérisé en ce que** la structure d'entraînement (2) a une construction multicouche dans le sens de la hauteur (5a) et dispose de plusieurs couches de matériau élastomère (42) empilées les unes sur les autres dans le sens de la hauteur (5a), dans lequel respectivement une couche d'électrodes (43a, 43b), sur laquelle une tension de commande peut être appliquée pour l'activation électrique de la structure d'entraînement (2), est disposée utilement entre les couches de matériau élastomère (42) voisines dans le sens de la hauteur (5a) et utilement aussi sur les surfaces frontales extérieures, orientées dans le sens de la hauteur (5a), des deux couches extérieures de matériau élastomère (42).

10. Actionneur élastomère selon la revendication 9, **caractérisé en ce que** les couches d'électrode (43a, 43b) sont raccordées alternativement à deux conducteurs de liaison en forme de bande (44a, 44b) qui se trouvent à l'extérieur sur la surface de la gaine (45) de la structure d'entraînement (2) et s'étendent dans le sens de la hauteur (5a).

11. Actionneur élastomère selon la revendication 10, **caractérisé en ce que** les couches de matériau élastomère (42) de la structure d'entraînement (2) ont un contour rectangulaire quand on les observe en coupe transversale perpendiculaire à l'axe vertical (5) et les couches d'électrodes (43a, 43b) ont également un contour rectangulaire, dans lequel les couches d'électrodes (43a, 43b) ont une surface de base plus petite que les couches de matériau élastomère (42) et sont placées de telle sorte que deux bords extérieurs adjacents (47a, 47b) de leurs quatre bords extérieurs (47a, 47b) sont respectivement à affleurement avec deux surfaces périphériques adjacentes (46) des quatre surfaces périphériques extérieures (46) des couches de matériau élastomère (42), dans lequel les couches d'électrodes (43a, 43b) sont affectées tour à tour à des zones en coin (52a, 52b) des couches de matériau élastomère (42) qui sont opposées en diagonale et dans lequel les conducteurs de liaison en forme de bande (44a, 44b) sont également utilement affectés à ces deux zones en coin (52a, 52b).

12. Actionneur élastomère selon l'une des revendications 1 à 11, **caractérisé en ce que** la structure de transmission des forces (17) dispose de propriétés flexibles dans chaque sens perpendiculaire au sens de la hauteur (5a) et/ou **en ce que** la structure de transmission des forces (17) repose à force contre la structure d'entraînement (2).

13. Actionneur élastomère selon l'une des revendications 1 à 12, **caractérisé en ce que** la structure de transmission des forces (17) et la section de libération des forces (15) sont solidement reliées en formant un corps de libération des forces (27) et sont notamment d'un seul tenant.

14. Actionneur élastomère selon l'une des revendications 1 à 13, **caractérisé en ce que** la structure de transmission des forces (17) et la section de libération des forces (15) sont réunies pour former un corps de libération des forces (27) maniable en un seul bloc.

15. Actionneur élastomère selon l'une des revendications 1 à 14, **caractérisé en ce qu'**il présente des moyens de serrage élastique (28) qui maintiennent la structure d'entraînement (2), la au moins une section de libération des forces (15) et la au moins une structure de transmission des forces (17) pour former un groupe de construction et qui sont formés utilement par un corps de gaine (28a) caoutchouteux entourant au moins partiellement par l'extérieur les composants (2, 15, 17) devant être maintenus ensemble.

16. Actionneur élastomère selon l'une des revendications 1 à 15, **caractérisé en ce qu'**au moins une section de libération des forces (15) présente au moins une interface de fixation (16) utilisable en particulier pour la fixation d'un composant externe.
